# EUROPEAN PATENT SPECIFICATION

(11) **EP 1 850 996 B1**
(45) Date of publication and mention of the grant of the patent: **11.04.2012**
(21) Application number: 06710828.2
(22) Date of filing: 04.02.2006
(51) Int. Cl.: B23K 1/018, D04C 1/06

(54) **LEAD FREE DESOLDERING BRAID**
BLEIFREIES ENTLÖTUNGSGEFLECHT
TRESSE A DESSOUDER SANS PLOMB

(30) Priority: 18.02.2005 US 62187
(43) Date of publication of application: 07.11.2007
(73) Proprietor: Illinois Tool Works Inc., Glenview IL 60026 (US)
(72) Inventor: KLEIN, Gary J., Los Angeles, California 90045 (US); MAX, Susan D., Kennesaw, Georgia 30114 (US)
(74) Representative: Finnie, Peter John
(86) International application number: PCT/IB2006/050372
(87) International publication number: WO 2006/087648

(56) References cited:
- EP-A- 0 338 552
- EP-A- 0 604 966
- US-A- 5 052 611
- US-A- 5 094 139
- ANONYMOUS: "QQ-W-343E" [Online] 26 March 2003 (2003-03-26), ALPHAWIRE , XP002386227 Retrieved from the Internet: URL:http://web.archive.org/web/20030326140 447/http://www.alphawire.com/pages/pdf/159 .pdf> [retrieved on 2006-06-20] page 159

## Description

The present invention pertains to a method of desoldering, using a braid that is configured for removing solder from, for example, printed circuit boards and electronic equipment, during the rework and repair of these electrical components. A such method is known from EP-A-604966.

Known desoldering braids have limited effectiveness on solders with melting points higher than 200°C (392°F). Currently U.S. electronics manufacturers use eutectic tin/ lead solder which has a melting point of 183°C (about 361°F). Due to regulatory requirements in Europe, namely the Waste Electrical and Electronic Equipment (WEEE) Directive and Reduction of Hazardous Substances (RoHS) Regulation (European Union Directive 2002/95/EC) which bans the use of leaded solders in new electronics products sold in Europe as of July 1, 2006, many manufacturers are now evaluating lead-free solders with melting points higher than 200°C with plans to convert their production processes to lead-free solder prior to the deadline.

The known braids cannot effectively operate at these elevated solder (melting point) temperatures. These braids are fabricated from hollow tubes that are woven and subsequently flattened to form the braid. This results in a 2-ply construction with the opposing walls of the tube forming the plies. While these braids are effective for the lower temperature solders, the heat transfer rate is too low for effectively desoldering components having the higher melting point temperature.

Accordingly, there exists a need for a desoldering method that is effective with higher melting pont, temperature solders. Desirably, the desoldering method uses a desoldering member that is formed in a manner similar to known members, such as desoldering braids. More desirably, the braid facilitates the desoldering operation by effectively increasing the heat transfer rate from the heat source to the solder that is to be removed.

### BRIEF SUMMARY OF THE INVENTION

According to the invention, a method of desoldering with the features of claim 1 is provided.

With this method, it is possible to desolder the printed circuit board or electrical component having a lead-free solder having a melting point temperature in excess of 183°C (about 361 °F).

Advantageously, the braid is formed from solid copper wire strands. Optionally, the braid can include a flux coating on the braid. Fluxes include no clean flux, rosin flux and the

According to a further aspect of the invention, the bundle may include about 4 to about 12 strands of copper wire and preferably 7 strands and the strands have a gauge of about 40 to about 44 and preferably a gauge of 42. The braid may include about 9 to about 17 bundles of strands and preferably 13 bundles braided in a 2 over 2 configuration. Alternately, the braid can be formed in a 1 over 1 configuration.

These and other features and advantages of the present invention will be apparent from the following detailed description, in conjunction with the appended claims.

### BRIEF DESCRIPTION OF THE SEVERAL VIEWS OF THE DRAWINGS

The benefits and advantages of the present invention will become more readily apparent to those of ordinary skill in the relevant art after reviewing the following detailed description and accompanying drawings, wherein:
FIG. 1 is a plan view of a lead free desoldering braid for use in the method of the present invention;

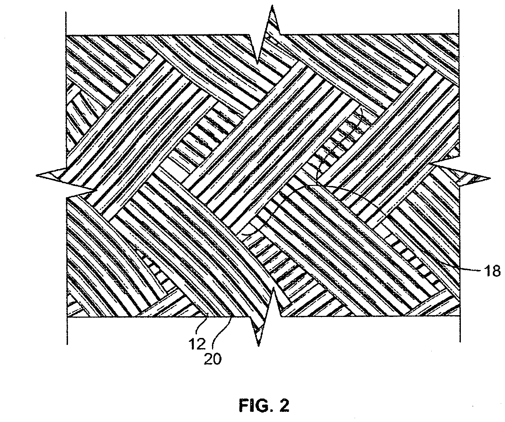

FIG. 2 is an enlarged, close-up view of the braid shown in a 2 over 2 configuration;
FIG. 3 is an end view of the braid of FIG. 3; and
FIG. 4 illustrates and alternate braid formed in a 1 over 1 configuration.

### DETAILED DESCRIPTION OF THE INVENTION

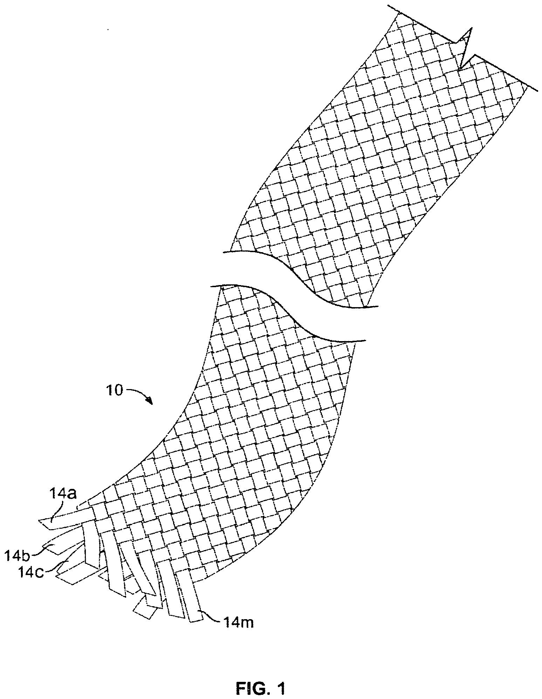

Referring now to FIG. 1, there is shown a desoldering braid 10 embodying the principles of the present invention. The braid 10 is formed as a single ply member or element. A plurality of solid strands 12 (e.g., 12a, 12b, 12c, ... 12g) are grouped together to form a bundle 14 of strands 12. A plurality of bundles 14 (e.g., 14a, 14b, 14c, ... 14m) are then braided together to form the braid 10. The braid 10 is formed as a single braided or interweaved layer (indicated generally at 16) in which each of the separate elements or, as in the present instance, strands 12 and bundles 14 are single ply. A present material for the desoldering braid 10 is copper. The configuration of the present braid 10 is in contrast to known braids in which the braided elements (i.e., tubes) are flattened which results in a two-ply configuration.

In a present braid 10, there are seven (7) strands 12 in each bundle 14, and thirteen (13) bundles 14 braided together to form the braid 10. In the braid 10, the strands 12 are 42 gauge wire. This produces a 13-7-42 braid. The braid 10 is formed (or woven) in a 2 over 2 configuration (indicated generally at 18) in which a bundle 14a is passed over (or passed under) the next two adjacent bundles 14b, 14c to form the woven braid 10. Such a braid 10 has a width w of about 0.083 inches (± 0.010 inches) (2.1 mm ± 0.25 mm) and a thickness t of about 0.014 inches (± 0.003 inches) (0.35mm ± 0.08 mm). It is, however, contemplated that other wire gauges, number of strands 12 (in each bundle 14), numbers of bundles 14 (in the braid 10) and braiding configurations 18 can be used to form the braid 10 of the present invention to achieve additional sizes and dimensions. For example, it is contemplated that suitable braids can be formed as 13-7-42 braids (13 bundles of seven strands of 42 gauge wire), 13-5-42 braids (13 bundles of five strands of 42 gauge wire) and 13-7-40 braids (13 bundles of seven strands of 40 gauge wire), as well as other sizes, numbers and configurations. The number of strands 12 can vary from about 4 to 12 strands per bundle 14, the wire (strand 12) gauge from about 40 to about 44 and the number of bundles 14 per braid 10 from about 9 to about 17.

This present braided configuration contains about 20 to 24 picks per inch (7,87 to 9,45 picks per cm) and measures about 0.083' (2.1 mm) wide by 0.014' (0.35 mm) thick. A pick is the distance between intersecting bundles (of wire). As set forth above, the present single thickness or single ply braid 10 (which resembles a ribbon), is unlike known desoldering braids having a 2-ply construction, in that the known braids are fabrication from a flattened tubular construction. It has been observed that considerably faster heat transfer (a greater heat transfer rate) occurs for melting lead-free solder when the single-ply braid is used for desoldering. This increases the speed and efficiency of the rework process and minimizes heat damage to the printed circuit board (PCB) and components. It has been found that the present braid functions to effectively remove solders having a melting point greater than about 183°C (about 361°F).

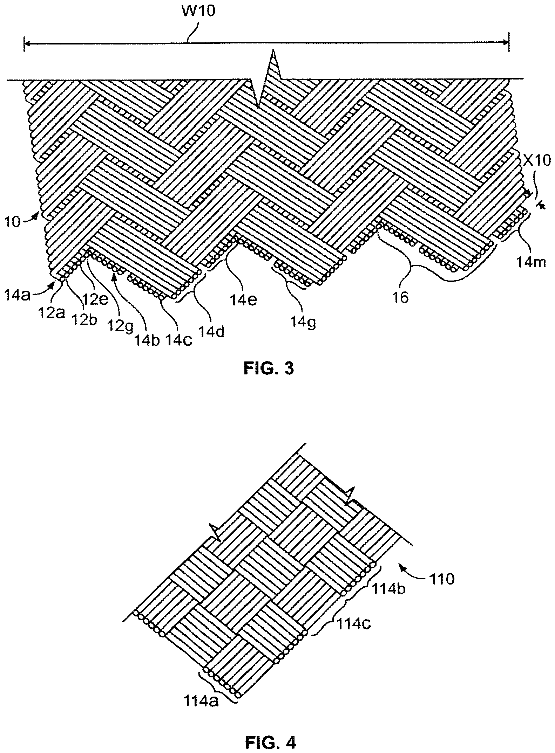

An alternate braid 110 is illustrated in FIG. 4. This braid is formed in a 1 over 1 configuration in which a bundle 114a alternates over and under each adjacent bundle 114b, 114c.

The braid 10, 110 can include a flux (indicated generally at 20), such as a high-temperature no clean flux. One suitable flux 20 is a no clean flux, varieties of which are commercially available, and can be suitably selected from Alpha Metals of Jersey City, New Jersey. This permits desoldering applications using higher temperatures, up to 400° C (752°F). Desoldering with a flux such as this is optimized without premature loss of flux to volatilization or degradation of the flux at higher temperatures. The residues remaining on the surface of the PCB when desoldering is complete are noncorrosive if left on the PCB. The residues from desoldering can be easily removed using solvent cleaners, if required. Another contemplated flux is a rosin flux.

It has been found that use of the present braid 10, 110 reduces the time needed to melt lead-free solder when a soldering iron (not shown) is used as a heat source. By applying the desoldering braid 10, 110 to the surface of the solder and touching the soldering iron to the desoldering braid 10, 110, heat is efficiently transferred through the desoldering braid 10, 110 to the solder to achieve the melting point of the solder. Solder may be removed in this manner from various locations on the PCB during rework and repair for the replacement of soldered components on the PCB. This technique can also be used to clean excess solder from the pads of the PCB after hot air removal of surface mount components to prepare the surface for the application of solder paste prior to hot air reflow of replacement components.

The manner in which the braid 10, 110 is formed will be recognized by those skilled in the art. For example, the braid 10, 110 may be formed using a flat braiding technique or, alternately, using a maypole braiding technique. All such braiding techniques are within the scope of the present invention.

In the present disclosure, the words 'a' or 'an' are to be taken to include both the singular and the plural. Conversely, any reference to plural items shall, where appropriate, include the singular.

From the foregoing it will be observed that numerous modifications and variations can be effectuated without departing from the scope of the appended claims.

## Claims

1. A method of desoldering a printed circuit board or electrical component having a lead-free solder, comprising:
providing a ribbon braid comprising a plurality of solid metal strands bundled together to form a bundle; and a plurality of bundles braided with one another to form the ribbon braid; and,
desoldering the printed circuit board or electrical component with the ribbon braid **characterized in that** the braid is a single ply ribbon braid, and **in that** the printed board or the electrical component, has a lead-free solder having a melting point temperature in excess of 183°C (about 361°F).

2. The method of claim 1 wherein the metal strands are copper.

3. The method of claim 1 including a flux coating on the braid.

4. The method of claim 3 wherein the flux is a no clean flux.

5. The method of claim 3 wherein the flux is a rosin flux.

6. The method of claim 1 wherein the bundle includes about 4 to about 12 strands of copper wire.

7. The method of claim 6 wherein the copper wire has a gauge of about 40 to about 44.

8. The method of claim 1 wherein the single ply ribbon braid includes about 9 to about 17 bundles of strands.

9. The method of claim 1 wherein the braid is braided in a 2 over 2 configuration.

10. The method of claim 1 wherein the single ply ribbon braid is braided in a 1 over 1 configuration.

## Patentansprüche

1. Verfahren zum Ablöten einer gedruckten Leiterplatte oder eines elektrischen Bauelements, das ein bleifreies Lötmittel aufweist, das Folgendes umfasst:
Bereitstellen einer Bandlitze, die mehrere massive Metalladern umfasst, die zusammen gebündelt sind, um ein Bündel zu bilden; und wobei mehrere Bündel miteinander verflochten sind, um die Bandlitze zu bilden; und
Ablöten der gedruckten Leiterplatte oder des elektrischen Bauelements mit der Bandlitze, **dadurch gekennzeichnet, dass** die Litze eine einlagige Bandlitze ist und dass die gedruckte Leiterplatte oder das elektrische Bauelement ein bleifreies Lötmittel mit einer Schmelzpunkttemperatur über 183 °C (etwa 361°F) aufweist.

2. Verfahren nach Anspruch 1, wobei die Metalladern aus Kupfer sind.

3. Verfahren nach Anspruch 1, das eine Flussmittelbeschichtung auf der Litze enthält.

4. Verfahren nach Anspruch 3, wobei das Flussmittel kein reines Flussmittel ist.

5. Verfahren nach Anspruch 3, wobei das Flussmittel ein Kunstharz-Flussmittel ist.

6. Verfahren nach Anspruch 1, wobei das Bündel etwa 4 bis etwa 12 Adern aus Kupferdraht enthält.

7. Verfahren nach Anspruch 6, wobei der Kupferdraht eine Drahtstärke von etwa 40 bis etwa 44 aufweist.

8. Verfahren nach Anspruch 1, wobei die einlagige Bandlitze etwa 9 bis etwa 17 Aderbündel enthält.

9. Verfahren nach Anspruch 1, wobei die Litze in einer 2-über-2-Konfiguration geflochten ist.

10. Verfahren nach Anspruch 1, wobei die einlagige Bandlitze in einer 1-über-1-Konfiguration geflochten ist.

## Revendications

1. Procédé de dessoudage d'une carte de circuit imprimé ou d'un composant électrique qui présente une soudure sans plomb, le procédé comprenant les étapes qui consistent à :
prévoir une tresse en ruban comprenant plusieurs brins en métal plein regroupés pour former un faisceau et plusieurs faisceaux regroupés les uns avec les autres pour former une tresse en ruban et
dessouder la carte de circuit imprimé ou le composant électrique de la tresse en ruban,
**caractérisé en ce que**
la tresse est une tresse en ruban en couche unique et
**en ce que** la carte de circuit imprimé ou le composant électrique présentent une soudure sans plomb dont la température de fusion est supérieure à 183°C (environ 361°F) .

2. Procédé selon la revendication 1, dans lequel les brins métalliques sont en cuivre.

3. Procédé selon la revendication 1, comprenant un revêtement fondant sur la tresse.

4. Procédé selon la revendication 3, dans lequel le fondant n'est pas un fondant propre.

5. Procédé selon la revendication 3, dans lequel le fondant est un fondant à la colophane.

6. Procédé selon la revendication 1, dans lequel le faisceau comprend d'environ 4 à environ 12 brins de fil de cuivre.

7. Procédé selon la revendication 6, dans lequel le calibre du fil de cuivre présente est compris entre environ 40 et environ 44.

8. Procédé selon la revendication 1, dans lequel la tresse en ruban en couche unique contient d'environ 9 à environ 17 faisceaux de brins.

9. Procédé selon la revendication 1, dans lequel la tresse est tressée dans une configuration 2 sur 2.

10. Procédé selon la revendication 1, dans lequel la tresse en ruban en couche unique est tressée dans une configuration 1 sur 1.
